# EUROPÄISCHE PATENTSCHRIFT

(11) **EP 3 507 559 B1**
(45) Veröffentlichungstag und Bekanntmachung des Hinweises auf die Patenterteilung: **07.09.2022**
(21) Anmeldenummer: 17746100.1
(22) Anmeldetag: 31.07.2017
(51) Int. Cl.: F28D 1/02, H01L 23/467, H01L 23/473, H05K 7/20

(54) **WÄRMETAUSCHERINTEGRATION**
HEAT EXCHANGER INTEGRATION
INTÉGRATION D'UN ÉCHANGEUR DE CHALEUR

(30) Priorität: 31.08.2016 DE 102016116276; 29.09.2016 DE 102016118556
(43) Veröffentlichungstag der Anmeldung: 10.07.2019
(73) Patentinhaber: ebm-papst Mulfingen GmbH & Co. KG, 74673 Mulfingen (DE)
(72) Erfinder: RENNER, Alexander, 74653 Weldingsfelden (DE); GOOTZ, Brunhilde, 55291 Saulheim (DE)
(74) Vertreter: Staeger & Sperling Partnerschaftsgesellschaft mbB
(86) Internationale Anmeldenummer: PCT/EP2017/069354
(87) Internationale Veröffentlichungsnummer: WO 2018/041501

(56) Entgegenhaltungen:
- DE-A1- 2 718 966
- DE-C- 890 025
- JP-A- 2005 221 191
- JP-A- 2007 287 957
- US-A- 2 368 732
- US-A- 2 662 748
- US-A- 5 078 206

## Beschreibung

Die Erfindung betrifft eine in einem Ventilator oder Gebläse integrierte Kühlkörperbaugruppe sowie einen Ventilator, insbesondere ein Radialgebläse mit integrierter Wärmetauscherfunktion.

Bisher werden im Stand der Technik zur Nutzung von Wärme Wärmetauscher als getrennte Komponente verwendet und mit einem Luft- oder Flüssigkeitsstrom mit einem warmen oder kalten Fluid beaufschlagt, je nachdem ob man Wärme Rückgewinnen will oder umgekehrt.

Dies erfordert jeweils eine individuelle räumliche und technische Adaption der verwendeten Komponenten.

Aus dem Stand der Technik ist bekannt, dass die Hauptkomponenten eines Lamellen-Rohr-Wärmetauschers Rohre und Lamellen sind. Typischerweise wird ein solcher Wärmetauscher so aufgebaut, dass an den Rohren gleichartige, zueinander parallele Lamellen befestigt sind, um die Wärmeübertragungsflächen zu vergrößern. Durch die Rohre strömt ein erstes Medium (meist Wasser) und kontaktiert ihre inneren Wände, während ein zweites Medium (meist Gas) ihre äußeren Wände und die Lamellenoberfläche kontaktiert. Die Lamellen haben Kontakt mit den äußeren Rohrwänden und dem zweiten Medium. Sie haben die Aufgabe, sobald eine Temperaturdifferenz zwischen den beiden Medien entsteht, die Wärme über die Rohrwände und Lamellenflächen von einem zum anderen Medium zu übertragen. Zum Anströmen der Lamellen mit dem zweiten Medium, wird regelmäßig ein externer Ventilator und ein Strömungskanal benötigt, um den vom Ventilator erzeugte Luftstrom in Richtung des Wärmetauschers zu lenken.

Aus der DE 10350358 A1 ist ein Verfahren und eine Vorrichtung mit einem Lüfter, einem Luftkanal und einem Wärmetauscher bekannt, wobei der Lüfter von einem Computer oder einem elektrischen Gerät erwärmte Abluft über den Luftkanal dem Wärmetauscher zuführt, wobei der Wärmetauscher einen Eingangsanschluss und einen Ausgangsanschluss aufweist, durch die der Wärmetauscher über ein Medium durchströmbar ist, welches sich durch die zugeführte erwärmte Abluft erwärmt.

Weiterer druckschriftlicher Stand der Technik im vorliegenden technischen Gebiet, welcher den Oberbegriff des Anspruchs 1 widerspiegelt, ist in den Druckschriften JP 2007 287957 A und US 5 078 206 A offenbart.

Nachteilig bei solchen im Stand der Technik bekannten Lösungen ist der Umstand, dass der Anwender jeweils eine individuelle Anpassung der Komponenten vornehmen muss, welche zumal abhängig von den örtlichen Gegebenheiten ist. Neben der Adaption an den vorhandenen Bauraum und die örtlichen Gegebenheiten, müssen auch aufwendige technische Abstimmungen vorgenommen werden. Nachteilig ist dabei eine platzraubende Bauweise des Wärmetauschers, der Luftströmkanäle und der benötigten Luftfördervorrichtungen sowie die damit verbundenen hohen Planungs-, Material- und Montagekosten. Aufgabe der vorliegenden Erfindung ist es, vorbesagte Nachteile zu überwinden und eine kompakte, kostengünstige und universell verwendbare Lösung bereit zu stellen, mit der eine Wärmetauscherfunktion realisiert werden kann.

Ein Grundgedanke der vorliegenden Erfindung ist es, einen Ventilator oder ein Gebläse, mit integrierter Wärmetauscherfunktion auszubilden, indem eine in einen Ventilator integrierbare Wärmetauscherbaugruppe aus einem Kühlkörper sowie in dem Kühlkörper integrierte Wärmetauscherkanäle und einem Tragringelement des Ventilators als Baugruppeneinheit ausgebildet wird.

Ein erster Aspekt der vorliegenden Erfindung betrifft daher eine um einen Radialventilator herum anbringbare Wärmetauscherbaugruppe gemäß Anspruch 1, wobei die Wärmetauscherbaugruppe aus einem im Wesentlichen zylinderförmigen Ventilatorkühlturm gebildet wird, der über einen Kühlkörper mit einer Vielzahl von strömungswirksam miteinander verbundenen Fluidkanälen für ein durchströmendes Kühlmedium verfügt, wobei der Ventilatorkühlturm eine Vielzahl von mit Luftleitlamellen durchsetzte, in Radialrichtung offene Luftdurchgänge zum Durchströmen der Luft des Radialventilators aufweist. Ferner sind jeweils benachbarte Fluidkanäle strömungswirksam an ihrem einen Ende über ein Ringkanalsegment mit dem einen unmittelbar benachbarten Fluidkanal und an dem anderen Ende mit dem weiteren benachbarten Fluidkanal über ein anderes Ringkanalsegment verbunden.

Bevorzugt wird hierzu ein Kühlturm aus einem Kühlkörper in dem integrierte Wärmetauscherkanäle vorgesehen sind, die auf einem Flansch montiert werden, realisiert.

In einer bevorzugten Ausführungsform der Erfindung ist vorgesehen, dass ferner das Tragringelement mit einer zentralen Luftdurchtrittsöffnung für den Ventilator vorgesehen ist, auf dem der zylindrische Ventilatorkühlturm mit seiner unteren Stirnseite aufsitzt bzw. montiert ist. Auf diese Weise kann der Radialventilator zusammen mit dem Kühlturm und dem Tragringelement sowie ggf. einem Abdeckflansch als komplette Baugruppeneinheit in eine Applikation integriert werden. Hierdurch wird eine besonders kompakte Bauform erzielt, die zumal universell einsetzbar ist und kostengünstig in der Herstellung und der Montage.

Die Luft wird über die strömungstechnisch angepasste zentrale Luftdurchtrittsöffnung in den Ventilator eingesaugt und über den seitlichen radial Ausblas des Radialrades entlang der Luftleitlamellen des Ventilatorkühlturms abgegeben. Dabei werden die von einem Kühlmedium durchflossenen Fluidkanäle des Ventilatorkühlturms von der Luft umströmt.

Die Wärmetauscherfunktion kann dabei ansaugend oder ausblasend oder auch beidseitig genutzt werden, je nach Anwendung d. h. je nachdem ob kalte oder warme Luft ein jeweils warmes oder kaltes Medium umströmt, oder auch umgekehrt.

Die durchströmende Luft des Ventilators wird durch das Medium in ihrer Temperatureigenschaft bewusst verändert, d. h. entweder heruntergekühlt oder erwärmt. Das bedeutet, dass ein durch die Fluidkanäle durchfließendes Medium seine Temperatureigenschaften ändert und demnach auch die durchströmende Luft.

Weiter vorteilhaft ist es, wenn die Vielzahl von Luftleitlamellen ringförmig, weiter vorzugsweise konzentrisch in einem gleichen Nachbarabstand zueinander um die Luftdurchtrittsöffnung angeordnet sind.

In einer weiteren bevorzugten Ausführungsform der Erfindung ist vorgesehen, dass der zylinderförmige Ventilatorkühlturm aus einem (vorzugsweise einzigen) Kühlringelement gebildet ist und die Fluidkanäle mäanderförmig umlaufend mit Axialabschnitten in und entgegen der Axialrichtung Z des zylinderförmigen Ventilatorkühlturms benachbart zu dessen Innenseite verlaufen. So kann mit Vorteil vorgesehen sein, dass zumindest sich in Axialrichtung Z erstreckende Axialabschnitte der Fluidkanäle im Inneren der Luftleitlamellen verlaufen.

Weiter kann mit Vorteil vorgesehen werden, dass die Axialabschnitte der Fluidkanäle jeweils durch eine Leitlamelle in zwei parallel verlaufende strömmungswirksam verbundene Fluidkanalabschnitte aufgeteilt werden, wobei der eine Fluidkanalabschnitt eine erste Fließrichtung für das Kühlmedium und der zweite Fluidkanalabschnitt eine der ersten Fließrichtung entgegengesetzte Fließrichtung definiert. Somit kann das Fluid in dem einen Abschnitt z. B. nach unten fließen, dann in den anderen Abschnitt fließen, um dort nach Oben zu fließen und dann durch den nächsten Fluidkanal zu fließen usw. bis des Fluid an einem Fluidkanalausgang wieder austritt.

In einer alternativen Ausgestaltung der Erfindung kann vorgesehen sein, dass der zylinderförmige Ventilatorkühlturm aus mehreren übereinander gestapelten Kühlringelementen gebildet ist und Fluidkanäle ringförmig umlaufend entlang, zwischen oder innerhalb der Kühlringelemente verlaufen.

Weiter vorteilhaft ist es, wenn eine obere Abdeckplatte auf der oberen, der unteren Stirnseite gegenüber liegenden Stirnseite des zylinderförmigen Ventilatorkühlturms montiert ist, welche zumindest Abschnittsweise eine Wandung für einen oder mehrere der Fluidkanäle bildet.

Ein weiterer Aspekt der vorliegenden Erfindung betrifft einen Ventilator, vorzugsweise einen Radialventilator ausgestattet mit einer der wie zuvor beschriebenen Wärmetauscherbaugruppen, wobei der Ventilator innerhalb des zylindrischen Aufnahmeraumes des zylinderförmigen Ventilatorkühlturms angeordnet ist.

In einer besonders bevorzugten Gestaltung der Erfindung ist vorgesehen, dass ein Kühlmediumzugang und ein Kühlmediumabgang mit den Fluidkanälen des Ventilatorkühlturms strömungswirksam verbunden sind.

Weiter vorteilhaft ist es, wenn der axiale Ansaugbereich des Radialventilators unmittelbar oberhalb der Luftdurchtrittsöffnung des Tragringelements (insbesondere strömungsoptimiert) angeordnet ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: eine perspektivische Ansicht eines Ausführungsbeispiels eines Radialventilators mit einem Teil einer Wärmetauscherbaugruppe;
- Fig. 2: eine Explosionsdarstellung eines Radialventilators und einer Wärmetauscherbaugruppe,
- Fig. 3: eine Schnittansicht durch das Ausführungsbeispiel gemäß Figur 2 in einem zusammengebauten Zustand;
- Fig. 4: eine teilgeschnittene Ansicht durch eine Wärmetauscherbaugruppe gemäß der Ausführung nach Figur 1;
- Fig. 5: eine perspektivische Ansicht eines Ausführungsbeispiels einer Wärmetauscherbaugruppe für einen Radialventilator;
- Fig. 6: eine Explosionsdarstellung einer weiteren alternativen Wärmetauscherbaugruppe,
- Fig. 7: eine teilgeschnittene Ansicht durch die Wärmetauscherbaugruppe gemäß der Ausführung nach Figur 6 im zusammengebauten Zustand;
- Fig. 8: eine seitliche Ansicht der Wärmetauscherbaugruppe gemäß der Ausführung nach Figur 7;
- Fig. 9: eine Explosionsdarstellung einer weiteren alternativen Wärmetauscherbaugruppe,
- Fig. 10: eine teilgeschnittene Ansicht durch die Wärmetauscherbaugruppe gemäß der Ausführung nach Figur 9 im zusammengebauten Zustand und
- Fig. 11: eine seitliche Ansicht der Wärmetauscherbaugruppe gemäß der Ausführung nach Figur 10.

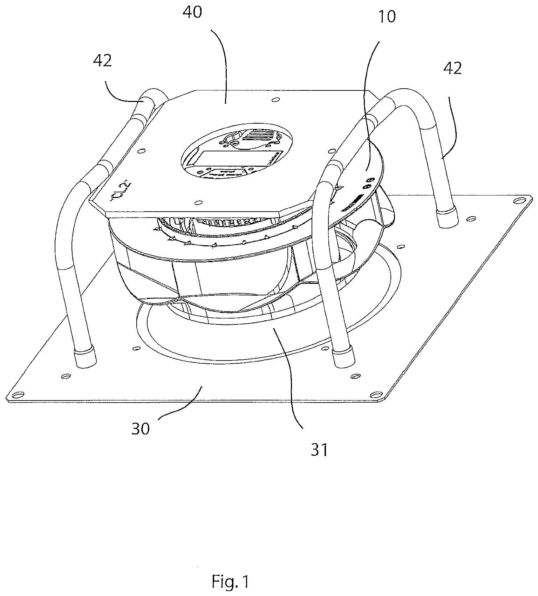

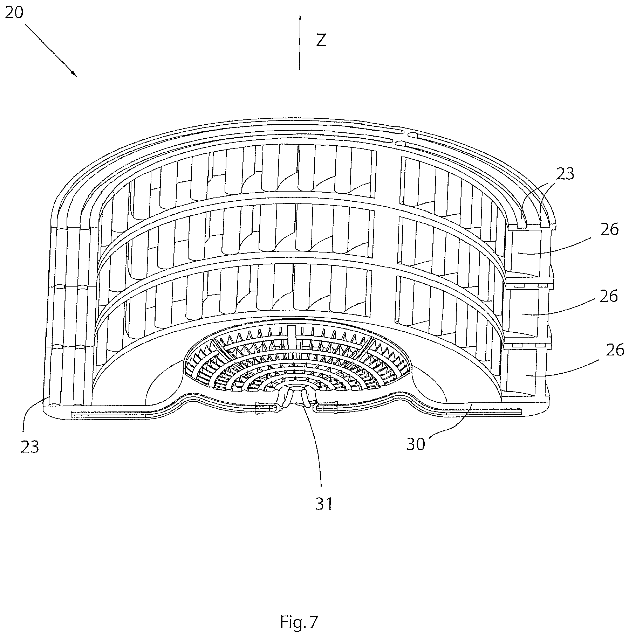

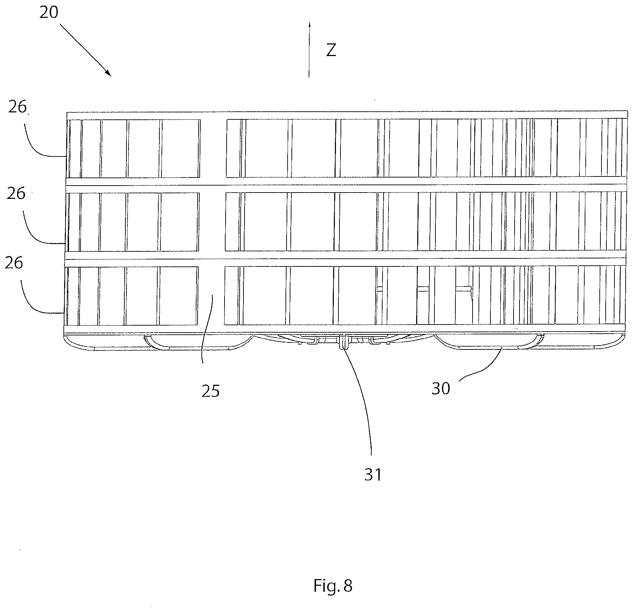

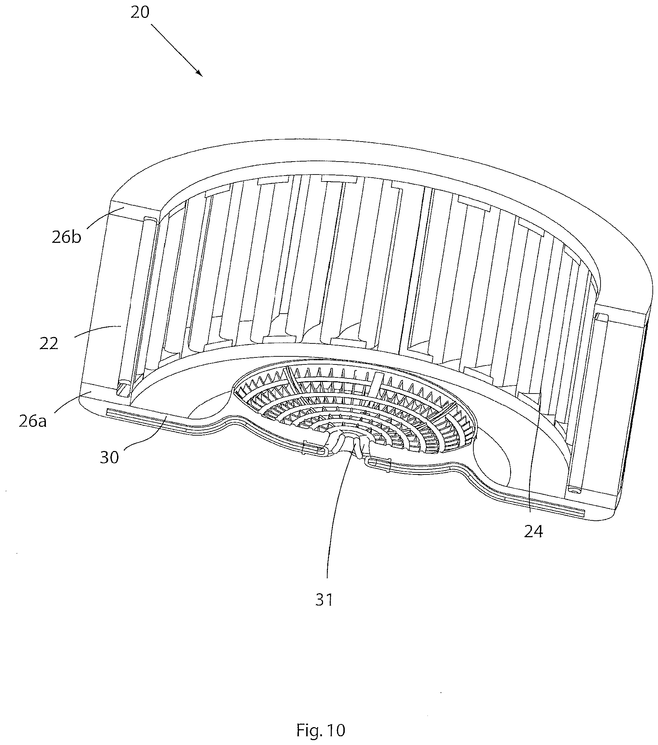

Im Folgenden wird die Erfindung anhand der Figuren 1 bis 10 näher erläutert, wobei gleiche Bezugszeichen auf gleiche strukturelle und/oder funktionale Merkmale hinweisen.

In der Fig. 1 ist eine perspektivische Ansicht eines Ausführungsbeispiels eines Radialventilators 10 mit einer integrierten Wärmetauscherbaugruppe 20 gezeigt.

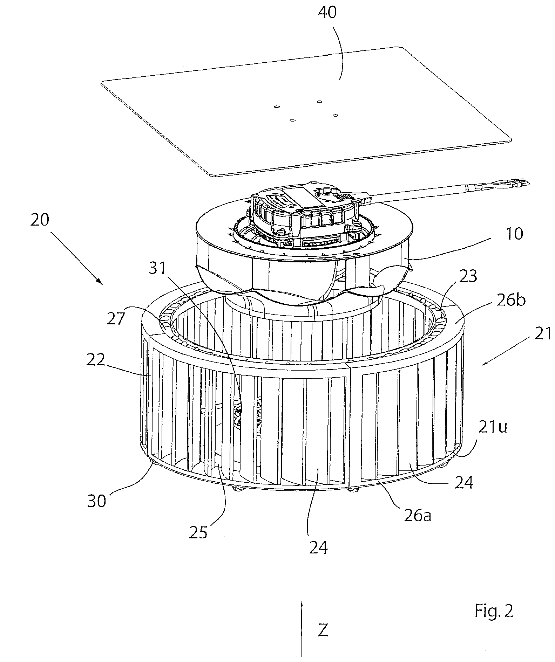

Drei beispielhafte Ausführungsformen für eine Wärmetauscherbaugruppe 20 finden sich in den Figuren 2 bis 10.

Gezeigt ist in Figur 1 ein Radialventilator 10 oberhalb eines Tragringelements 30 einer Wärmetauscherbaugruppe 20. Das Tragringelement 30 ist mit einer zentralen Luftdurchtrittsöffnung 31 für den Radialventilator 10 ausgestattet. Oberhalb des Radialventilators 10 befindet sich eine Abdeckplatte 40, die mit dem Tragringelement 30 über zwei Bügel 42 verbunden ist.

In der Fig. 2 ist eine Explosionsdarstellung eines Radialventilators 10 und einer Wärmetauscherbaugruppe 20 gezeigt sowie einer Abdeckplatte 40 oberhalb des Ventilators 10. Die Wärmetauscherbaugruppe 20 besteht aus dem zylindrischen Ventilatorkühlturm 21, der Abdeckung 40 und dem Tragringelement 30, welches mit seiner unteren Stirnseite 21u auf dem Tragringelement 30 um den Radialventilator 10 herum montiert.

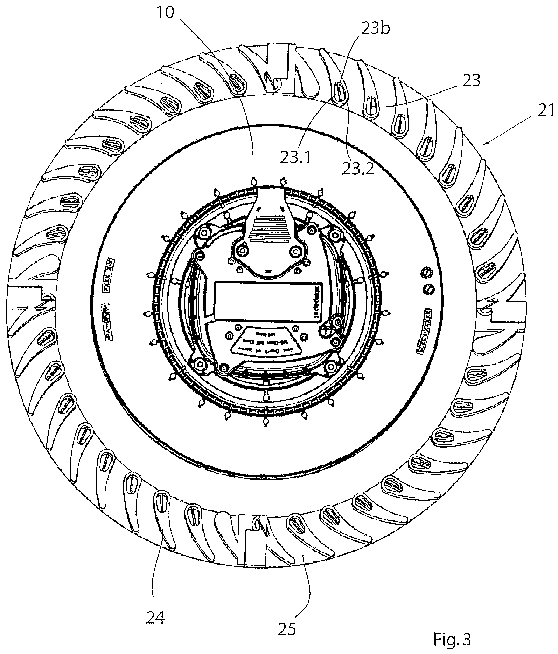

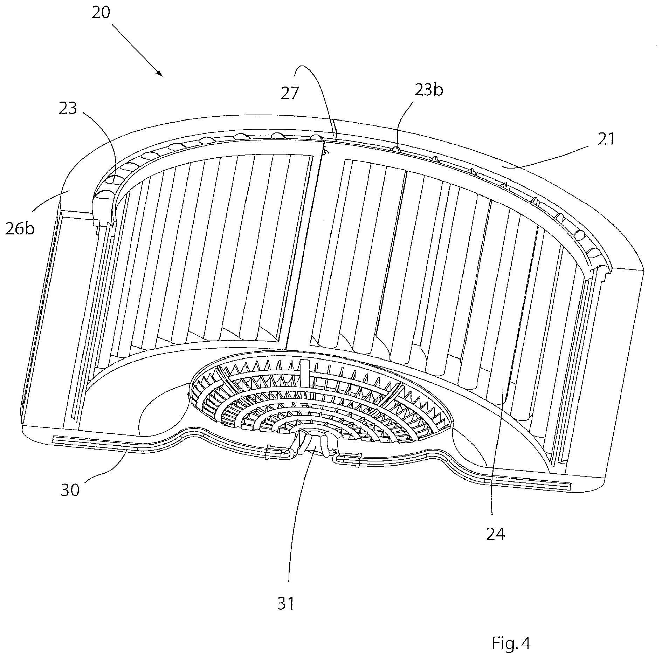

Der zylinderförmigen Ventilatorkühlturm 21 besteht, wie in den Figuren 3 und 4 ersichtlich, aus einem Kühlkörper 22, der eine Vielzahl von mit Luftleitlamellen 24 durchsetzte in Radialrichtung verlaufende Luftdurchgänge 25 zum Durchströmen der Luft des Ventilators 10 aufweist. Die Luftleitlamellen 24 verlaufen in Axialrichtung Z zwischen einem unteren Ringelement 26a und einem oberen Ringelement 26b. Die Vielzahl von Luftleitlamellen 24 sind ringförmig um die Luftdurchtrittsöffnung 31 des Tragringelements 30 angeordnet. In den Luftleitlamellen 24 sind Fluidkanäle 23 für ein flüssiges Medium vorgesehen. Die Fluidkanäle 23 verlaufen entlang der Axialrichtung Z im Wesentlichen über die gesamte Höhe der Luftleitlamellen 24. Insofern verlaufen die Axialabschnitte der Fluidkanäle 23 im Inneren der Luftleitlamellen 24 und sind an ihrem oberen Kanalende 23o über einen oben umlaufenden Ringkanal 27 strömungswirksam miteinander verbundenen. Erfindungsgemäß sind die Ringkanäle in Ringkanalsegmente unterteilt.

Die Axialabschnitte der Fluidkanäle 23 sind jeweils durch eine Leitlamelle 23b in zwei parallel verlaufende Fluidkanalabschnitte 23.1, 23.2 aufgeteilt, wobei der eine Fluidkanalabschnitt 23.1 eine erste Fließrichtung für das Kühlmedium und der zweite Fluidkanalabschnitt 23.1 eine der ersten Fließrichtung entgegengesetzte Fließrichtung definiert, so dass ein Fluid mäanderförmig von einem zum nächsten d. h. benachbarten Fluidkanal 23 fließen kann, indem ein Fluid in dem einen Fluidkanalabschnitt 23.1 des betreffenden Fluidkanals 23 in und in dem anderen Fluidkanalabschnitt 23.2 des betreffenden Fluidkanals 23 entgegen der Axialrichtung Z des zylinderförmigen Ventilatorkühlturms 21 fließt um dann am oberen Fluidkanalende in dem Ringkanal 27 zum benachbarten Fluidkanal zu fließen usw..

Auf diese Weise kann das Fluid von einem nicht dargestellten Fluideintritt nacheinander durch die Fluidkanäle 23 fließen, um dann an einem ebenfalls nicht dargestellten Fluidaustritt wieder auszutreten.

Da die Fluidkanäle 23 benachbart zu der Innenseite des Kühlkörpers 21 in den Luftleitlamellen untergebracht sind, wird das Fluid mittelbar durch die Wärmübertragung zwischen dem Fluid und der den Kühlkörper durchströmenden Luft (je nach Richtung des Temperaturgefälles) entweder erwärmet oder gekühlt.

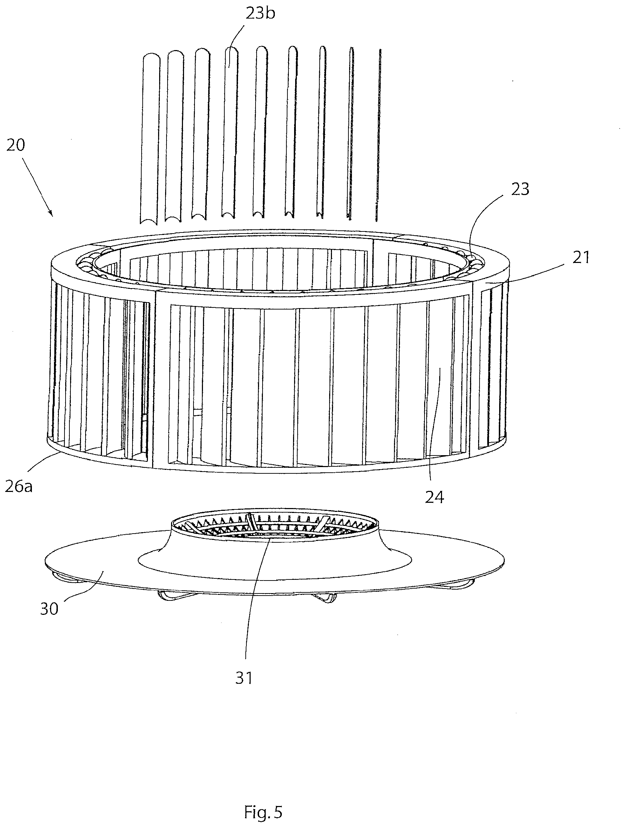

In der Fig. 5 ist die perspektivische nicht zusammengebaute Ansicht der Wärmetauscherbaugruppe 20 für einen Radialventilator gezeigt, bei dem die Leitlamellen 23b im nicht eingesteckten Zustand gezeigt sind.

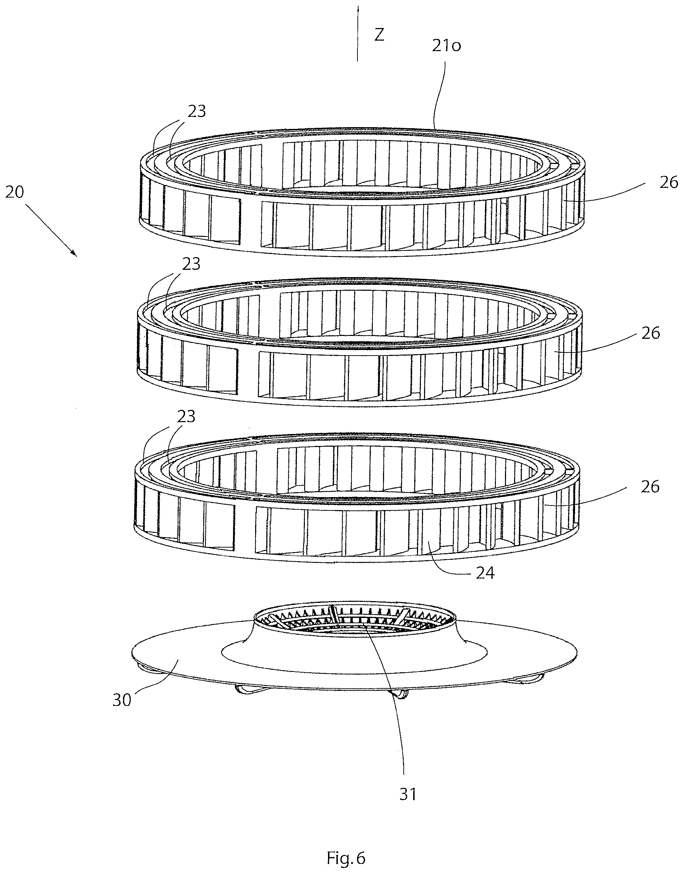

In den Figuren 6, 7 und 8 ist eine weitere Ausführungsform einer Wärmetauscherbaugruppe 20 gezeigt. Die Wärmetauscherbaugruppe 20 ist in dieser Variante derart ausgebildet, dass der zylinderförmige Ventilatorkühlturm 21 aus mehreren übereinander gestapelten Kühlringelementen 26 gebildet ist und die Fluidkanäle 23 jeweils ringförmig umlaufend innerhalb der Kühlringelementen 26 integriert verlaufen. Hierbei werden die Fluidkanäle 23 der einzelnen Kühlringelemente 26 strömungswirksam miteinander so verbunden, dass ein Fluid durch mehrere der ringförmigen Fluidkanäle 23 nacheinander fließt. Alternativ aber nicht als Teil der Erfindung kann auch jeder Fluidkanal 23 getrennt mit einem Fluidstrom beaufschlagt werden.

Eine obere Abdeckplatte 40, die auf der oberen, der unteren Stirnseite 21u gegenüber liegenden Stirnseite 21o des zylinderförmigen Ventilatorkühlturms 21 montiert ist, bildet zumindest Abschnittsweise eine Wandung für den oberen Fluidkanal 23 aus. In ähnlicher Weise verschließt eine Abdeckplatte den Ringkanal 27 in dem zuvor genannten Ausführungsbeispiel.

Nicht näher dargestellt ist ferner ein Kühlmediumzugang und ein Kühlmediumabgang, die mit den Fluidkanälen 23 strömungswirksam verbunden sind, um ein Fluid zu- und abzuführen.

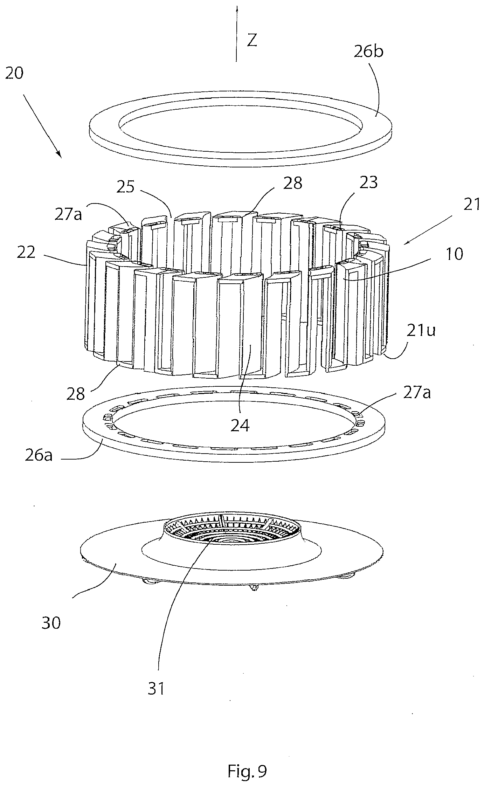

In den Figuren 9, 10 und 11 ist eine weitere Ausführungsform einer Wärmetauscherbaugruppe 20 gezeigt. Der zylinderförmige Ventilatorkühlturm 21 ist hier aus einer Vielzahl von mäanderförmig miteinander verbundenen Luftleitlamellen 24 gebildet, die an ihrer Unterseite mit einem unteren Ringelement 26a und an der Oberseite und mit einem oberen Ringelement 26b verschlossen sind.

Innerhalb der Luftleitlamellen 24 verlaufen in Axialrichtung Z die Fluidkanäle 23, wobei je ein Fluidkanal 23 innerhalb einer Luftleitlamelle 24 untergebracht ist. Jeweils benachbarte Fluidkanäle 23 sind strömungswirksam an ihrem einen Ende über ein Ringkanalsegment 27a mit dem einen unmittelbar benachbarten Fluidkanal 23 und an dem anderen Ende mit dem weiteren benachbarten Fluidkanal 23 über ein anderes Ringkanalsegment 27a verbunden. Die oberen je zwei Fluidkanäle 23 verbindenden Ringkanalsegmente 27a sind in den die beiden benachbarten Luftleitlamellen 24, welche diese Fluidkanäle 23 aufweisen, jeweils verbindenden Brücken 28 untergebracht. Alternativ oder zusätzlich können diese Ringkanalsegmente auch in dem oberen Ringelement 26b angeordnet sein und strömungswirksam mit den offenen Fluidkanälen 23 verbunden sein, wie dies in der Figur 9 beispielsweise für das untere Ringelement 26a gezeigt ist.

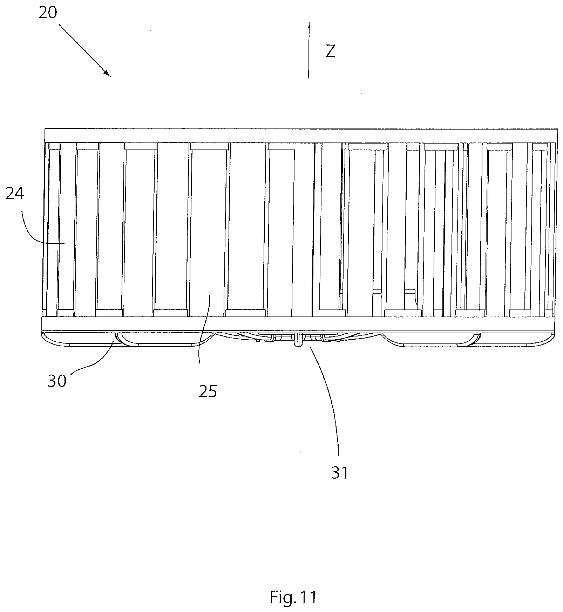

Die Figur 11 zeigt eine seitliche Ansicht dieser Wärmetauscherbaugruppe 20.

Die Erfindung beschränkt sich in ihrer Ausführung nicht auf die vorstehend angegebenen bevorzugten Ausführungsbeispiele. Vielmehr ist entsprechend den nachfolgenden Ansprüchen eine Anzahl von Varianten denkbar, welche von der dargestellten Lösung auch bei grundsätzlich anders gearteten Ausführungen Gebrauch macht.

## Patentansprüche

1. Eine um einen Ventilator (10) herum anbringbare Wärmetauscherbaugruppe (20), wobei die Wärmetauscherbaugruppe (20) aus einem im Wesentlichen zylinderförmigen Ventilatorkühlturm (21) gebildet wird, der über einen Kühlkörper (22) mit einer Vielzahl von strömungswirksam miteinander verbundenen Fluidkanälen (23) für ein flüssiges Medium verfügt, wobei der Ventilatorkühlturm (21) eine Vielzahl von mit Luftleitlamellen (24) durchsetzte in Radialrichtung verlaufende Luftdurchgänge zum Durchströmen der Luft des Ventilators (10) aufweist, **dadurch gekennzeichnet, dass** jeweils benachbarte Fluidkanäle (23) strömungswirksam an ihrem einen Ende über ein Ringkanalsegment (27a) in einem oberen Ringelement (26b) mit dem einen unmittelbar benachbarten Fluidkanal (23) und an dem anderen Ende mit dem weiteren benachbarten Fluidkanal (23) in einem unteren Ringelement (26a) über ein weiteres Ringkanalsegment (27a) verbunden sind.

2. Wärmetauscherbaugruppe (20) gemäß Anspruch 1, **dadurch gekennzeichnet, dass** ferner ein Tragringelement (30) mit einer zentralen Luftdurchtrittsöffnung (31) für einen Ventilator (10) vorgesehen ist, auf dem der zylindrische Ventilatorkühlturm (21) mit seiner unteren Stirnseite (21u) montiert ist.

3. Wärmetauscherbaugruppe (20) gemäß Anspruch 2, **dadurch gekennzeichnet, dass** die Vielzahl von Luftleitlamellen (24) ringförmig um die Luftdurchtrittsöffnung (31) angeordnet sind.

4. Wärmetauscherbaugruppe (20) gemäß Anspruch 1, 2 oder 3, **dadurch gekennzeichnet, dass** der zylinderförmige Ventilatorkühlturm (21) aus einem Kühlringelement (26) gebildet ist und die Fluidkanäle (23) mäanderförmig umlaufend mit Axialabschnitten (23a) in und entgegen der Axialrichtung (Z) des zylinderförmigen Ventilatorkühlturms (21) benachbart zu dessen Innenseite (21i) entlang verlaufen.

5. Wärmetauscherbaugruppe (20) gemäß einem der Ansprüche 1 bis 4, **dadurch gekennzeichnet, dass** zumindest sich in Axialrichtung (Z) erstreckende Axialabschnitte (23a) der Fluidkanäle (23) im Inneren der Luftleitlamellen (24) verlaufen.

6. Wärmetauscherbaugruppe (20) gemäß einem der Ansprüche 3 bis 5, **dadurch gekennzeichnet, dass** die Axialabschnitte (23a) der Fluidkanäle jeweils durch eine Leitlamelle (23b) in zwei parallel verlaufende Fluidkanalabschnitte (23.1, 23.2) aufgeteilt werden, wobei der eine Fluidkanalabschnitt (23.1) eine erste Fließrichtung für das Kühlmedium und der zweite Fluidkanalabschnitt (23.1) eine der ersten Fließrichtung entgegengesetzte Fließrichtung definiert.

7. Wärmetauscherbaugruppe (20) gemäß Anspruch 1, 2 oder 3, **dadurch gekennzeichnet, dass** der zylinderförmige Ventilatorkühlturm (21) aus mehreren übereinander gestapelten Kühlringelementen (26) gebildet ist und die Fluidkanäle (23) ringförmig umlaufend entlang oder innerhalb der Kühlringelemente (26) verlaufen.

8. Wärmetauscherbaugruppe (20) gemäß einem der Ansprüche 2 bis 6, **dadurch gekennzeichnet, dass** eine obere Abdeckplatte (40) auf der oberen, der unteren Stirnseite (21u) gegenüber liegenden Stirnseite (21o) des zylinderförmigen Ventilatorkühlturms (21) montiert ist, welche zumindest Abschnittsweise eine Wandung für einen oder mehrere der Fluidkanäle (23) bildet.

9. Ventilator (1) vorzugsweise ein Radialventilator (1) ausgestattet mit einer Wärmetauscherbaugruppe (20) nach einem der Ansprüche 1 bis 8, wobei der Ventilator innerhalb des zylindrischen Aufnahmeraumes des zylinderförmigen Ventilatorkühlturms (21) angeordnet ist.

10. Ventilator (1) nach Anspruch 9, wobei ein Kühlmediumzugang und ein Kühlmediumabgang mit den Fluidkanälen (23) strömungswirksam verbunden sind.

11. Radialventilator (1) ausgestattet mit einer Wärmetauscherbaugruppe (20) nach einem der Ansprüche 2 bis 8, wobei der axiale Ansaugbereich des Radialventilators (1) unmittelbar oberhalb der Luftdurchtrittsöffnung (31) des Tragringelements (30) der Wärmetauscherbaugruppe (20) angeordnet ist.

## Claims

1. A heat exchanger assembly (20) attachable around a fan (10), wherein the heat exchanger assembly (20) is formed from a substantially cylindrical fan cooling tower (21) which has a heat sink (22) with a plurality of fluid channels (23) for a liquid medium, which fluid channels are fluidically connected to each other, wherein the fan cooling tower (21) has a plurality of air passages for the air of the fan (10) to flow through, through which air passages air-guiding fins (24) extend and which air passages extend in the radial direction, **characterized in that** in each case adjacent fluid channels (23) are fluidically connected at their one end to the one immediately adjacent fluid channel (23) via an annular channel segment (27a) in an upper annular element (26b) and at the other end to the further adjacent fluid channel (23) in a lower annular element (26a) via a further annular channel segment (27a).

2. The heat exchanger assembly (20) according to claim 1, **characterized in that** further a support ring element (30) with a central air passage opening (31) for a fan (10) is provided, on which the cylindrical fan cooling tower (21) is mounted with its lower end face (21u).

3. The heat exchanger assembly (20) according to claim 2, **characterized in that** the plurality of air-guiding fins (24) is arranged annularly around the air passage opening (31).

4. The heat exchanger assembly (20) according to claim 1, 2 or 3, **characterized in that** the cylindrical fan cooling tower (21) is formed from a cooling ring element (26) and the fluid channels (23) are meandering circumferentially with axial portions (23a) running along in and opposite the axial direction (Z) of the cylindrical fan cooling tower (21) adjacent to the inner side (21i) thereof.

5. The heat exchanger assembly (20) according to any one of claims 1 to 4, **characterized in that** at least axial portions (23a) of the fluid channels (23) extending in the axial direction (Z) run inside the air-guiding fins (24).

6. The heat exchanger assembly (20) according to any one of claims 3 to 5, **characterized in that** the axial portions (23a) of the fluid channels are each divided by a guide fin (23b) into two fluid channel portions (23.1, 23.2) extending in parallel, wherein the one fluid channel section (23.1) defines a first flow direction for the cooling medium and the second fluid channel section (23.1) defines a flow direction opposite to the first flow direction.

7. The heat exchanger assembly (20) according to claim 1, 2 or 3, **characterized in that** the cylindrical fan cooling tower (21) is formed from a plurality of cooling ring elements (26) stacked on top of each other and the fluid channels (23) extend circumferentially and annularly along or inside the cooling ring elements (26).

8. The heat exchanger assembly (20) according to any one of claims 2 to 6, **characterized in that** an upper cover plate (40) is mounted on the upper end face (21o), opposite the lower end face (21u), of the cylindrical fan cooling tower (21), which upper cover plate, at least in certain sections, forms a wall for one or more of the fluid channels (23).

9. A fan (1), preferably a radial fan (1), equipped with a heat exchanger assembly (20) according to any one of claims 1 to 8, wherein the fan is arranged within the cylindrical receiving space of the cylindrical fan cooling tower (21).

10. The fan (1) according to claim 9, wherein a cooling medium inlet and a cooling medium outlet are fluidically connected to the fluid channels (23).

11. The radial fan (1), equipped with a heat exchanger assembly (20) according to any one of claims 2 to 8, wherein the axial intake region of the radial fan (1) is arranged directly above the air passage opening (31) of the support ring element (30) of the heat exchanger assembly (20).

## Revendications

1. Ensemble d'échangeur de chaleur (20) pouvant être installé autour d'un ventilateur (10), dans lequel l'ensemble d'échangeur de chaleur (20) est formé par une tour de refroidissement de ventilateur (21) substantiellement cylindrique qui dispose d'un dissipateur de chaleur (22) pourvu d'une pluralité de canaux de fluide (23), reliés les uns aux autres de manière fluidique, pour un milieu liquide, la tour de refroidissement de ventilateur (21) présentant une pluralité de passages d'air s'étendant dans la direction radiale, traversés par des ailettes déflectrices d'air (24) et servant à la circulation de l'air du ventilateur (10), **caractérisé en ce que** des canaux de fluide (23) respectivement adjacents sont reliés de manière fluidique au niveau d'une extrémité par l'intermédiaire d'un segment de canal annulaire (27a) dans un élément annulaire supérieur (26b) audit un canal de fluide (23) directement adjacent, et sont reliés au niveau de l'autre extrémité audit autre canal de fluide (23) adjacent dans un élément annulaire inférieur (26a) par l'intermédiaire d'un autre segment de canal annulaire (27a).

2. Ensemble d'échangeur de chaleur (20) selon la revendication 1, **caractérisé en ce qu'**en outre un élément d'anneau porteur (30) pourvu d'une ouverture de passage d'air centrale (31) est prévu pour un ventilateur (10) sur lequel est montée la tour de refroidissement de ventilateur (21) cylindrique par sa face frontale inférieure (21u).

3. Ensemble d'échangeur de chaleur (20) selon la revendication 2, **caractérisé en ce que** la pluralité d'ailettes déflectrices d'air (24) est disposée en forme d'anneau autour de l'ouverture de passage d'air (31).

4. Ensemble d'échangeur de chaleur (20) selon la revendication 1, 2 ou 3, **caractérisé en ce que** la tour de refroidissement de ventilateur (21) cylindrique est formée par un élément annulaire de refroidissement (26), et les canaux de fluide (23) s'étendent de manière périphérique en forme de méandre avec des parties axiales (23a) dans et à l'opposé de la direction axiale (Z) de la tour de refroidissement de ventilateur (21) cylindrique, de manière adjacente à la face intérieure (21i) de celle-ci.

5. Ensemble d'échangeur de chaleur (20) selon l'une quelconque des revendications 1 à 4, **caractérisé en ce que** des parties axiales (23a), s'étendant au moins dans la direction axiale (Z), des canaux de fluide (23) s'étendent à l'intérieur des ailettes déflectrices d'air (24).

6. Ensemble d'échangeur de chaleur (20) selon l'une quelconque des revendications 3 à 5, **caractérisé en ce que** les parties axiales (23a) des canaux de fluide sont respectivement divisées par une ailette déflectrice (23b) en deux parties de canal de fluide (23.1, 23.2) s'étendant en parallèle, ladite une partie de canal de fluide (23.1) définissant une première direction d'écoulement pour le milieu de refroidissement et la deuxième partie de canal de fluide (23.1) définissant une direction d'écoulement opposée à la première direction d'écoulement.

7. Ensemble d'échangeur de chaleur (20) selon la revendication 1, 2 ou 3, **caractérisé en ce que** la tour de refroidissement de ventilateur (21) cylindrique est formée par plusieurs éléments annulaires de refroidissement (26) empilés les uns sur les autres, et les canaux de fluide (23) s'étendent de manière périphérique en forme d'anneau le long ou à l'intérieur des éléments annulaires de refroidissement (26).

8. Ensemble d'échangeur de chaleur (20) selon l'une quelconque des revendications 2 à 6, **caractérisé en ce qu'**une plaque de recouvrement supérieure (40) est montée sur la face frontale supérieure (21o), opposée à la face frontale inférieure (21u), de la tour de refroidissement de ventilateur (21) cylindrique, qui forme au moins par endroits une paroi pour un ou plusieurs des canaux de fluide (23).

9. Ventilateur (1), de préférence ventilateur radial (1), équipé d'un ensemble d'échangeur de chaleur (20) selon l'une quelconque des revendications 1 à 8, dans lequel le ventilateur est disposé à l'intérieur de l'espace de réception cylindrique de la tour de refroidissement de ventilateur (21) cylindrique.

10. Ventilateur (1) selon la revendication 9, dans lequel une entrée de milieu de refroidissement et une sortie de milieu de refroidissement sont reliées de manière fluidique aux canaux de fluide (23).

11. Ventilateur radial (1), équipé d'un ensemble d'échangeur de chaleur (20) selon l'une quelconque des revendications 2 à 8, dans lequel la zone d'aspiration axiale du ventilateur radial (1) est disposée directement au-dessus de l'ouverture de passage d'air (31) de l'élément d'anneau porteur (30) de l'ensemble d'échangeur de chaleur (20).
